# EUROPEAN PATENT SPECIFICATION

(11) **EP 4 449 570 B1**
(45) Date of publication and mention of the grant of the patent: **24.09.2025**
(21) Application number: 22829819.6
(22) Date of filing: 12.12.2022
(51) Int. Cl.: G01K 1/02, G01K 1/024, G01K 3/14, G01K 3/00, H02G 5/06

(54) **HEAT SENSOR ASSEMBLY AND METHOD FOR POWER DISTRIBUTION SYSTEMS**
WÄRMESENSORANORDNUNG UND VERFAHREN FÜR ENERGIEVERTEILUNGSSYSTEME
ENSEMBLE CAPTEUR DE CHALEUR ET PROCÉDÉ POUR SYSTÈMES DE DISTRIBUTION D'ÉNERGIE

(30) Priority: 14.12.2021 GB 202118052
(43) Date of publication of application: 23.10.2024
(73) Proprietor: Eaton Intelligent Power Limited, Dublin 4 (IE)
(72) Inventor: HOPE, John, Sheffield South Yorkshire S36 9AN (GB)
(74) Representative: Gill Jennings & Every LLP
(86) International application number: PCT/GB2022/053182
(87) International publication number: WO 2023/111535

(56) References cited:
- WO-A1-2017/174994
- JP-A- S63 245 214
- KR-A- 20160 041 725
- US-A1- 2019 120 890

## Description

### FIELD OF INVENTION

The present invention relates to heat sensor assemblies, heat sensing systems comprising multiple such assemblies and methods of heat sensing all suitable for use in power distribution systems. The invention also relates to power distribution systems incorporating such heat sensor assemblies and sets of busbar segments for such systems.

### BACKGROUND

Bus duct or overhead bus trunking is becoming a widely used method of power distribution in all types of commercial buildings. This enables power to be distributed from point to point in a quick and flexible manner with the ability to place 'tap offs' at various points and re-configure the layout of the system far more efficiently than is possible using standard cables. This also negates the need for 'containment' to be installed for the cabling.

There are many manufacturers of such bus duct systems globally and all are very similar in design. Typical systems comprise a metal box-like tube structure with busbar conductors internally. These are commonly manufactured in pre-set lengths of around 3 to 4 metres, which connect into each other with either bespoke connector pieces or simply slot into each other with a male-to-female plug / socket approach. Prebuilt angles and T-pieces are also manufactured so this allows for a complex system to be installed quickly.

One problem encountered with all these systems is weight. Bus duct components are heavy items, holding up to four lengths of copper of aluminium busbar with ratings from 25A to 6300A. This weight can be in the region of tens of kilograms for short lengths, up to hundreds of kilograms for a larger system.

As with any system, joints are the weakest point and are generally the points which will be the area of concern if a failure is to occur. In typical bus duct power distribution systems, there are numerous joints, e.g. between any two bus duct segments and between a bus duct segment and a tap off.

Due to the weight of the system, very careful and solid support is required. The bus duct segments are generally connected to either surrounding steelwork or the building fabric itself. Over time and in extremes of temperatures this support structure can and does move, putting strain on the joints which in turn weakens and causes compromised electrical connections. These supports can also stretch if incorrect materials are used or not enough support is provided, again this leads to compromised joints. In all cases, when the joints move and become compromised, they generate heat which undetected can cause an equipment outage or at worst a catastrophic failure of the system leading to large downtime of an organisation. As an example, this downtime can lead to losses in the region of many hundreds of thousands of dollars per year, for typical organisations.

Currently, there is no definitive method of continuously monitoring bus duct systems for compromised joints. To date the only way to way to check the status of the system is to perform an inspection, either visually or with the use of thermal imaging cameras. This leads to many issues, being a time-based inspection, generally performed annually, and the variance of loads. Simple visual inspection from floor level does not always allow the user to detect sags or bending in the structure.

Systems based on fibre optic technology that are used for fire detection or leaking pipe detection also exist. These systems utilise RAMAN scattering, involving firing a laser signal down the whole length of the fibre, such that some of the light scatters and reflects to the controller unit. This scattering alters with changes in temperature and allows a temperature profile to be built along the fibre. This system is expensive and generally aimed at subsea cables, large pipe system, oil and gas distribution and tunnel fire detection. Such systems are not suitable for detecting compromised joints in bus duct power distribution systems, because they are very expensive (approx. $40,000 for a 1000 metre system), complicated to configure and commission, bulky and require rack-mounted space for each controller.

It would be desirable to provide a solution to the problem which overcomes at least some of these disadvantages.

KR-A-20160041725 discloses a multi-point temperature monitoring system for a bus duct which is configured for automatic recognition of its temperature sensing units, allowing quick installation and easy replacement of broken or damaged temperature sensors.

### SUMMARY OF INVENTION

A first aspect of the present invention provides a heat sensor assembly for a power distribution system, comprising:
a cable, containing a plurality of at least three heat sensors arranged along the length of the cable, each of the heat sensors being spaced from the next by an interval;
a end module at a first end of the cable, the end module having a corresponding plurality of terminal pairs, each terminal pair being dedicated to one of the heat sensors;
circuitry inside the cable, connecting each of the heat sensors across a corresponding one of the terminal pairs such that each terminal pair outputs a temperature signal indicative of the temperature sensed by the corresponding heat sensor; and
a controller configured to receive the temperature signal from each terminal pair and to compare the temperature signals against one another to determine whether the temperature sensed by any one of the heat sensors differs from that sensed by the other heat sensors by more than a predetermined threshold (ΔT_{ALARM}), and if so to generate an alarm signal.

A heat sensor assembly of this sort provides a simple-to install, simple to use and low-cost solution to the problem of detecting compromised joints in power distribution systems formed of bus ducts. The cable containing the heat sensors can either be attached to the outside of the outer case of the bus duct (e.g. by a cable tie or clamp assembly), allowing for straightforward retrofitting to an existing power distribution system or can be fitted inside the bus duct, e.g. during installation of the system. The assembly makes use of the fact that, if all joints are operating correctly, their temperatures should be approximately equal to one another. However, if a joint is compromised (e.g. loose or even open) excess heat will be generated locally thereby increasing the temperature of that joint relative to the other joints. The heat sensors can be fitted such that one is positioned adjacent a different joint in the power distribution system. The controller (which may be comprised in the end module or provided remotely) then compares the temperature signals from each heat sensor and if one differs in temperature from the others by more than a pre-set amount (ΔT_{ALARM}), an alarm will be generated. This enables the system operator to be alerted to a compromised joint substantially immediately upon occurrence of the fault, rather than waiting for an annual inspection to take place. In this way, faults can be repaired quickly and costly downtime avoided.

The circuitry may be implemented in various different ways. In a particularly preferred embodiment, the circuitry comprises a corresponding plurality of measurement lines and a common return line, each of the measurement lines connecting one of the heat sensors to a first terminal of the respective terminal pair in the end module, and the common return line connecting each of the heat sensors to a second terminal of the respective terminal pair in the end module. This approach minimises the number of cores required to be carried by the cable and therefore allows the use of a relatively small diameter cable.

The circuitry could for instance be provided by the use of any form of multi-core cable providing at least the number of lines needed to obtain each of the temperature signals. For instance, a 7-core cable (approximately 6 mm diameter) could be used, with each heat sensor connected across the relevant two cores at the appropriate locations along the cable length. It would also be possible to use standard CAT5 or CAT6 patch cables to form at least part of the cable, between heat sensors.

The controller may be implemented by firmware, hardware or software (or any combination thereof) and will typically be provided on a local card to which the terminal pairs are connected (e.g. via connectors which can be coupled and uncoupled, or hardwired via a terminal strip), although in other cases the controller could be located remotely. The determination as to whether the temperature sensed by any one of the heat sensors differs from that sensed by the other heat sensors by more than a predetermined threshold (ΔT_{ALARM}) could be achieved by any technique which will identify an "odd one out" of the signals. In a first preferred implementation, the controller is configured to compare the temperature signals by:
for each of the temperature signals, calculating the difference between that temperature signal and each other temperature signal; and
comparing each of the calculated differences against the predetermined threshold (ΔT_{ALARM}).

In a second preferred implementation, the controller is configured to compare the temperature signals by:
calculating an average of all of the temperature signals;
for each of the temperature signals, calculating the difference between that temperature signal and the calculated average; and
comparing each of the calculated differences against the predetermined threshold (ΔT_{ALARM}).

In a third preferred implementation, the controller is configured to compare the temperature signals by:
for each of the temperature signals, calculating an average of all of the other temperature signals and then calculating the difference between the temperature signal and the calculated average; and
comparing each of the calculated differences against the predetermined threshold (ΔT_{ALARM}).

The value of the predetermined threshold (ΔT_{ALARM}) may be factory-set or user-configurable, e.g. via DIP switches provided on the control unit, or via a suitable software tool. The value may depend on the particular method by which the comparison is carried out. In preferred examples, the predetermined threshold (ΔT_{ALARM}) is any of: 4 degrees C, 8 degrees C, 12 degrees C, 16 degrees C, 20 degrees C, 24 degrees C, 28 degrees C, or 32 degrees C. In an embodiment, each of these (or other) options could be made available for selection by a user, e.g. via the provision of a set of 3 DIP switches.

The alarm signal could be output in any convenient manner, e.g. via a sounder or a light (either local to the controller or on a panel elsewhere), and/or via a wired or wireless data connection to another device such as a central controller. The alarm signal preferably includes identification of which heat sensor has triggered the alarm signal. This enables the compromised joint to be quickly identified and repaired.

The heat sensor assembly could be provided as a single integral unit, e.g. a continuous cable into which the heat sensors are wired at the appropriate locations. However, in other cases it is advantageous to provide the heat sensor assembly in a modular manner, e.g. for joining together on-site. In such cases the cable preferably comprises two or more cable segments, the cable segments being detachably joined to one another by connectors, the connectors preferably including keying features such that they couple in a single relative orientation. The connectors may take the form of plug and socket connectors for instance, e.g. RJ45 plugs and corresponding sockets. Preferably, each cable segment comprises a heat sensor cable sub-section and a linking cable sub-section, optionally detachably joined to one another by a connector, the heat sensor cable sub-section comprising at least one of the heat sensors. If the heat sensor cable sub-section and the linking cable sub-section are detachable from one another, the heat sensor assembly could thus be provided as a kit of parts comprising a plurality of heat sensor cable sub-sections and a plurality of linking cable sub-sections, one of which is provided with the end module (optionally including the controller). The various parts can then be plugged together to form the complete assembly. Preferably the connectors will be configured so that they only allow connection in a single orientation to ensure the correct lines are connected. The heat sensor cable sub-sections may be labelled to ensure they are joined up in the correct order.

Whether the heat sensor assembly comprises a unitary cable or multiple cable segments, the circuitry and heat sensors are all enclosed within the cable, e.g. inside an outer sheath. The outer sheath may itself be continuous along the assembly or could be formed of multiple joined parts corresponding to the cable segments.

The heat sensor assembly could comprise any number of heat sensors greater than two. In preferred implementations the plurality of heat sensors includes at least six heat sensors, or at least eight heat sensors. In particularly preferred implementations the heat sensor assembly comprises exactly six or exactly eight heat sensors. The greater the number of heat sensors, the greater the number of lines required and hence the thicker the cable, which may be disadvantageous.

The heat sensors will be spaced at intervals along the length of the cable which are preferably substantially equal to one another. The interval may be selected based on typical spacing of joints in standard bus duct systems. For example, in preferred embodiments the intervals between the heat sensors may each be between 2 and 4 metres, more preferably approximately 3 metres. Thus a heat sensor assembly comprising six heat sensors at 3 metre intervals will enable 15 metres of bus duct to be monitored.

Any type of heat sensor could be utilised in the assembly although preferably all the heat sensors are of the same type. Desirably the heat sensors are contact-type heat sensors designed to be placed in close proximity with the joint to be monitored and to undergo a corresponding temperature increase if the joint generates heat. In preferred embodiments, each of the plurality of heat sensors comprises a thermistor, a thermocouple, a resistance temperature detector (RTD) or a semiconductor based sensor.

The controller may optionally be configured to perform one or more further routines, e.g. to provide a back-up alarm signal. Thus in a preferred embodiment, the controller is further configured to compare each temperature signal against a pre-set critical temperature threshold (T_{CRIT}) and to generate an alarm signal if any of the temperature signals is greater than the pre-set critical temperature threshold (T_{CRIT}). In this way, should any one or more of the heat sensors detect an abnormally high temperature (beyond T_{CRIT}) an alarm will be generated. This can be used to detect erroneously high loads being applied to the power distribution system e.g. due to an upstream failure, for instance. The value of the predetermined threshold (T_{CRIT}) may be factory-set or user-configurable, e.g. via DIP switches provided on the control unit, or via a suitable software tool. In preferred examples, T_{CRIT} may be set at any of 55 degrees C, 60 degrees C, 65 degrees C, 70 degrees C, 80 degrees C. 85 degrees C, or 90 degrees C. In an embodiment, each of these (or other) options could be made available for selection by a user, e.g. via the provision of a set of 3 DIP switches.

In another preferred embodiment, the heat sensor assembly may further comprise an ambient temperature sensor (e.g. an additional heat sensor located away from any of the joints, preferably adjacent the controller) configured to output an ambient temperature signal to the controller. The controller is preferably further configured to, for each temperature signal, calculate the difference between the temperature signal and the ambient temperature signal, to compare the difference against a pre-set critical temperature difference threshold (ΔT_{CRIT}) and to generate an alarm signal if the difference is greater than the pre-set critical temperature difference threshold (ΔT_{CRIT}). This provides a more accurate way to monitor for abnormal high temperatures since any local fluctuations to the ambient temperature will be taken into account, thereby reducing false positives. In a preferred example, the controller may be configured to generate a warning alarm signal if a first value of ΔT_{CRIT} is surpassed, and a critical alarm signal if a second, greater value of ΔT_{CRIT} is passed. For example the warning value ΔT_{CRIT} may be 30 degrees C and the critical value ΔT_{CRIT} may be 40 degrees C, in line with the NETA standard.

The heat sensor assembly could be a standalone unit designed to issue a local alert if an alarm signal is generated, e.g. via a light or a sounder. However in preferred embodiments the assembly may also or alternatively further comprise a communications module for outputting the temperature signals and/or any alarm signal from the controller to an external device, such as a central controller e.g. in the form of a computer. The communications module could be configured to communicate with a central controller via the MODBUS protocol, for instance.

Typically each controller will need to be powered and therefore the heat sensor assembly preferably further comprises a power module for supplying power to the controller from a local or external power source. If a local power source is used, this could comprise a battery or a solar cell. The power module may include an adapter for converting an AC input from an external power source into a DC supply to the controller. Alternatively, the external power source could be a DC power source.

A second aspect of the invention provides a heat sensor system comprising a plurality of heat sensor assemblies each in accordance with the first aspect of the invention, wherein the respective controllers (each forming part of the end module) are each supplied with power from a common power source. Preferably this common power source is a DC power supply.

Each of the controllers could be provided with an individual power adapter and arranged to receive power from the mains supply. However, more preferably the controllers are grouped into two or more sets, each set comprising at least two of the controllers, each set of controllers being provided with an input power connection for receiving power from the common power source and an output power connector for supplying power to another of the sets. This simplifies installation and reduces the number of parts required. Further heat sensor assembles can be added to the system in a "plug and play" manner.

In preferred embodiments, the system further comprises a central controller (such as a computer or control panel), the respective controllers being configured to communicate with the central controller, wherein the controllers are preferably grouped into two or more sets, each set comprising at least two of the controllers, each set of controllers being provided with data connections for exchanging data with the central controller and/or with another of the sets. Again, this grouping of the controllers into sets simplifies installation by reducing the number of connections that need to be made. Communication could be via the MODBUS protocol, as mentioned above.

In particularly preferred implementations, the input power connection, output power connection and data connections are provided by a RJ45 socket input and a RJ45 socket output at each set of controllers. For example, each set of (e.g. two) controllers could be placed into a respective housing which is provided with a single RJ45 socket input and a single RJ45 socket output for providing data and power to/from the controllers (which may be implemented as datacards). The plurality of heat sensor assemblies can then be connected into the system using standard cables such as CAT5 or other Ethernet cables to transmit both power and communications in a simple manner.

A third aspect of the invention provides a set of busbar segments for a power distribution system, each busbar segment comprising an elongate housing containing conductors for distributing power in use, the conductors extending along the elongate length of the housing between connection points at each end for joining to another one of the busbar segments, and each busbar segment further comprising a heat sensor assembly segment comprising a cable segment including at least one heat sensor and connectors at each end of the cable segment, configured such that when the set of busbar segments is connected, the joined cable segments form a cable containing a plurality of at least three heat sensors arranged along the length of the cable, each of the heat sensors being spaced from the next by an interval, and circuitry inside the cable, connecting each of the heat sensors across one of a corresponding plurality of terminal pairs at a first end of the cable, to which an end module can be provided in use, such that each terminal pair outputs a temperature signal indicative of the temperature sensed by the corresponding heat sensor.

As described above, the heat sensor assembly of the first aspect may be provided in a modular form. In the third aspect of the invention, the said modules are provided in combination with busbar segments such that installation of the heat sensor assembly can be perform simultaneously with construction of the power distribution system. The cable segments may be located inside the busbar segments or may be attached externally. Preferably, each cable segment comprises a heat sensor cable sub-section and a linking cable subsection, optionally detachably joined to one another by a connector, the heat sensor cable sub-section comprising at least one of the heat sensors. For example, the set may be provided as a kit of parts comprising a plurality of busbar segments each having a linking cable sub-section running its length, and a corresponding plurality of heat sensor cable sub-sections. When the busbar segments are installed, a heat sensor cable sub-section can then be used to connect each pair of adjacent linking cable sub-sections at the location of each joint. In this way, all of the busbar segments can be manufactured to an identical specification (including the linking cable sub-section) and only the set of heat sensor cable sub-sections will need to be configured differently for each joint position (with each heat sensor being connected to a different pair of lines in the cable). As before, the heat sensor cable sub-sections may be labelled to ensure they are connected in the correct order. An end module providing connections from the terminal pairs to a controller can then be provided. The controller is configured to receive the temperature signal from each terminal pair and to compare the temperature signals against one another to determine whether the temperature sensed by any one of the heat sensors differs from that sensed by the other heat sensors by more than a predetermined threshold (ΔT_{ALARM}), and if so to generate an alarm signal, as explained above.

A fourth aspect of the invention provides a power distribution system comprising one or more busbar segments containing conductors for distributing power in use, and a heat sensor assembly according to the first aspect or a heat sensor system according to the second aspect, arranged such that each heat sensor is positioned adjacent a joint in the power distribution system, preferably a joint between busbar segments or a joint between a busbar segment and a power outlet optionally affixed thereto.

A fifth aspect of the invention provides a method of monitoring for faulty connections in a power distribution system comprising one or more busbar segments containing conductors for distributing power in use, comprising:
providing a plurality of at least three heat sensors, each heat sensor being positioned adjacent a joint in the power distribution system, preferably a joint between busbar segments or a joint between a busbar segment and a power outlet optionally affixed thereto;
monitoring a temperature signal output by each of the plurality of heat sensors;
comparing the temperature signals against one another to determine whether the temperature sensed by any one of the heat sensors differs from that sensed by the other heat sensors by more than a predetermined threshold (ΔT_{ALARM}), and if so generating an alarm signal;
wherein the method is implemented using a heat sensor assembly according to the first aspect of the invention.

The method provides all the advantages described with respect to the first aspect.

As indicated above, the comparison leading to generation of the alarm signal can be performed in various different ways. In a first preferred embodiment, comparing the temperature signals comprises:
for each of the temperature signals, calculating the difference between that temperature signal and each other temperature signal; and
comparing each of the calculated differences against the predetermined threshold (ΔT_{ALARM}).

In a second preferred embodiment, comparing the temperature signals comprises:
calculating an average of all of the temperature signals;
for each of the temperature signals, calculating the difference between that temperature signal and the calculated average; and
comparing each of the calculated differences against the predetermined threshold (ΔT_{ALARM}).

In a third preferred embodiment, comparing the temperature signals comprises:
for each of the temperature signals, calculating an average of all of the other temperature signals and then calculating the difference between the temperature signal and the calculated average; and
comparing each of the calculated differences against the predetermined threshold (ΔT_{ALARM}).

The method may further involve performing one or more additional functions, e.g. to provide back-up alarms. Preferably the method further comprises comparing each temperature signal against a pre-set critical temperature threshold (T_{CRIT}) and generating an alarm signal if any of the temperature signals is greater than the pre-set critical temperature threshold (T_{CRIT}). The method may further comprise: providing an ambient temperature sensor; and for each temperature signal, calculating the difference between the temperature signal and the ambient temperature, comparing the difference against a pre-set critical temperature difference threshold (ΔT_{CRIT}) and generating an alarm signal if the difference is greater than the pre-set critical temperature difference threshold (ΔT_{CRIT}).

### DESCRIPTION OF DRAWINGS

Embodiments of the present invention will now be described, by way of example only with reference to the accompanying drawings in which:
Figure 1 schematically shows a portion of a conventional power distribution system, disassembled;
Figure 2 schematically shows a portion of a power distribution system according to an embodiment of the present invention;
Figure 3 depicts an embodiment of a heat sensor assembly in accordance with the present invention, not to scale;
Figure 4(a) schematically shows exemplary circuitry which may be provided in the heat sensor assembly of Figure 3;
Figure 4(b) shows an exemplary component of an end module in plan view which may be used with the circuitry of Figure 4(a);
Figures 5(a) to (d) show parts of another embodiment of a heat sensor assembly in accordance with the present invention;
Figure 6 schematically shows one of a set of busbar segments in accordance with an embodiment of the present invention; and
Figure 7 schematically shows an embodiment of a heat sensor system in accordance with the present invention.

### DETAILED DESCRIPTION

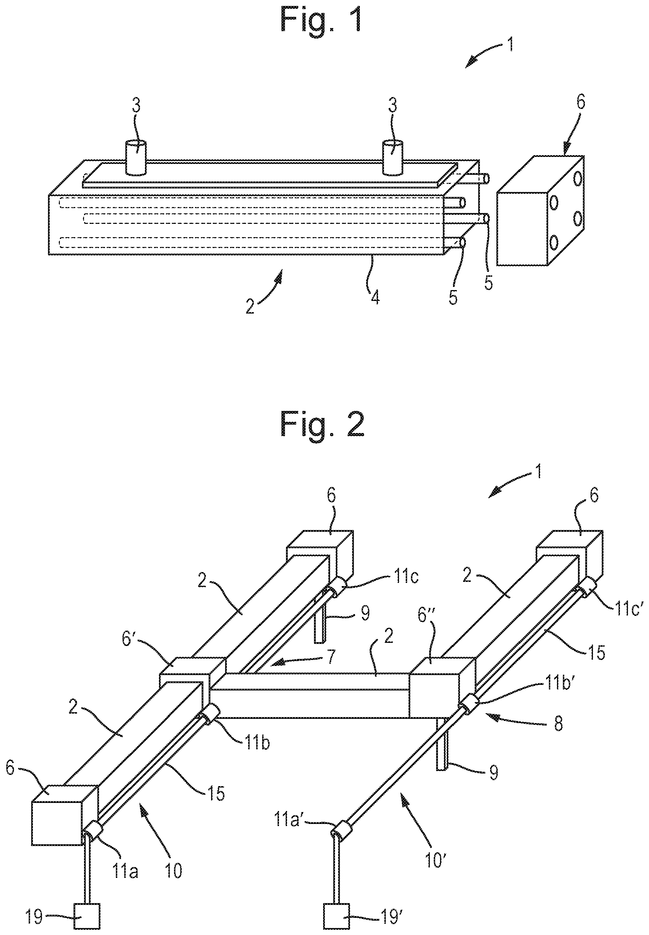

For context, Figure 1 schematically shows selected components of a conventional bus duct power distribution system 1. The system 1 comprises a plurality of busbar segments 2 (of which only one is shown), which typically each comprise an outer casing 4 formed of metal, housing a number of busbar conductors 5 extending along the elongate length of the segment 2. Mounting fixtures 3 are provided for fitting the busbar system to a structure such as a building. The busbar segments 2 are typically provided in standard lengths such as 3 metres. To distribute power to the locations required, multiple busbar segments are connected using joint kits 6. The joint kits 6 form electrical connections between the conductors 5 of one segment 2 and those of the next. As described above, movement of the supporting structure and hence of the busbar segments 2 relative to one another can, over time, lead to the joints becoming loose and therefore compromised. A compromised electrical connection will rise in temperature due to the increased electrical resistance.

Figure 2 shows a typical bus duct layout of a power distribution system 1 in accordance with an embodiment of the invention. In this example, the system comprises multiple busbar segments 2 connected by joint kits 6. Joint kit 6' is a T-joint, enabling another set of conductors to branch off, while joint kit 6" is an elbow joint used for redirecting the system around a corner. Tap-offs 9 are provided at selected joints for connection to the devices to be powered by the system (not shown). The power distribution system 1 is provided with at least one heat sensor assembly 10 (here a second heat sensor assembly 10' is also shown). The heat sensor assembly 10 will be described in more detail below. In Figure 2 it can be seen that the heat sensor assembly 10 comprises a plurality of heat sensors 11a, 11b, 11c which are incorporated into a cable 15 along which they are spaced at intervals. Each heat sensor 11a, 11b, 11c is placed adjacent one of the joints in the power distribution system. At one end of the cable 15 an end module comprising a controller 19 is provided which receives the temperature signals from the heat sensors 11a, 11b, 11c and determines whether an alarm should be generated. Each controller 19 may be provided with an output module for either indicating an alarm or communicating the alarm to an external device such as a central controller.

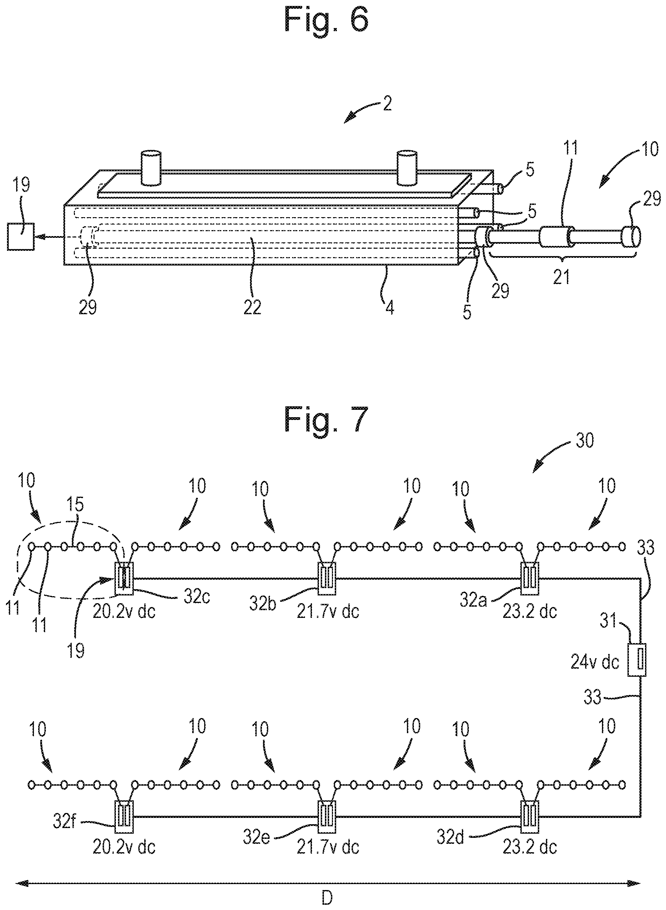

It should be noted that while Figure 2 depicts the heat sensor assemblies 10, 10' as being located on the exterior of the bus duct system, the heat sensor assemblies could instead be located inside the bus duct housings, as exemplified below with reference to Figure 6. This may be appropriate where the heat sensing system is installed at the same time as the installation of the power distribution system, for example. In contrast, external fitting allows the heat sensor system to be retro-fitted to existing installations.

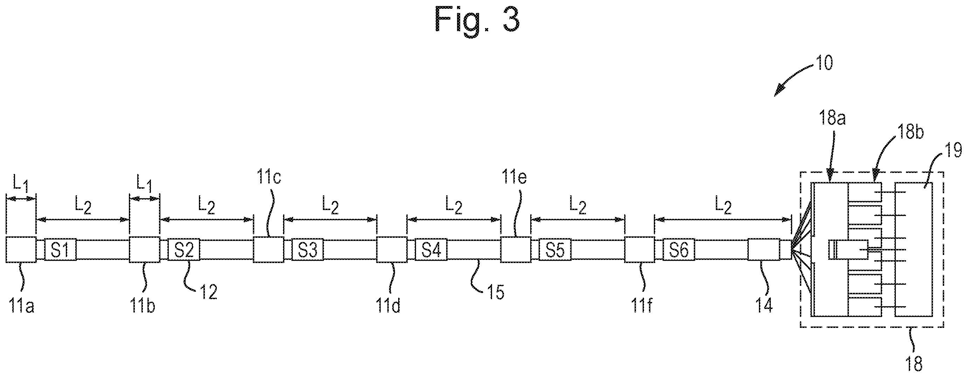

Figure 3 shows an embodiment of a heat sensor assembly 10 in more detail (not to scale). The heat sensor assembly 10 can be implemented as a low-cost sensor loom which can be simply attached to the outer case of the bus duct 2 by cable ties or a clamp assembly (or could be fitted internally). The assembly 10 presents as a single (multi-core) cable 15 rather than multiple separate cables, which simplifies installation.

The heat sensor assembly 10 comprises a plurality of separate heat sensors 11, such as thermistors or thermocouples (or other heat sensor technology), spaced along the cable 15 at intervals. Contact-type heat sensors such as these examples are generally preferred. In this embodiment, the heat sensor assembly 10 comprises six heat sensors 11a to 11f, each spaced by an interval of approximately 3 metres from the next. In practice these intervals are selected to correspond with the joints 6 of the trunking 2 in the power distribution system. As such, the interval distance may be varied to fit the system in question. Typically the interval will be in the range 2 to 4 metres. Preferably, the interval between each heat sensor on the cable is the same, but this is not essential. The exemplary heat sensor assembly 10 shown, having six sensors each spaced 3 metres apart, will allow us to monitor 15 metres of bus duct per sensor loom. The cable 15 may be provided with labels 12 for quick identification of each heat sensor. The cable 15 may be moulded at each sensor location to house the heat sensors 11 around the main cable so that the heat sensors and the cable circuitry are contained within an outer cable sheath. In an example the moulded regions may have a length L₁ of about 25mm and a diameter of about 7mm, while the sections of cable 15 between them may have a length L₂ of about 3 metres and a diameter of about 6mm. Item 14 is an optional ambient temperature sensor.

The cable 15 contains circuitry connecting each of the heat sensors 11 to an end module 18 which comprises a plurality of terminals, here embodied as pins 18b. In this example, the end module comprises a connector 18a carrying pins 18b, for coupling with corresponding connections to controller 19, e.g. a plus and socket connector. However, the connections from the terminals to the controller 19 can be made in any convenient way, including hard-wiring of the terminals to the controller 19 via a terminal strip. The circuitry connects each heat sensor 11 across a pair of the terminals 18b (constituting a "terminal pair") such that a corresponding temperature signal from the heat sensor is output across the pair. The terminals are connected to a controller 19, typically implemented on a local datacard, which receives the temperature signals from each of the heat sensors 11. The controller 19 is configured to carry out a comparison between the temperature signals and to ascertain whether any one of the temperature signals differs from the other temperature signals by more than a predetermined amount (ΔT_{ALARM}) as will be described in more detail below. If so, this is indicative of a fault at the corresponding joint where the heat sensor returning the high temperature signal is located and the controller 19 generates an alarm signal accordingly.

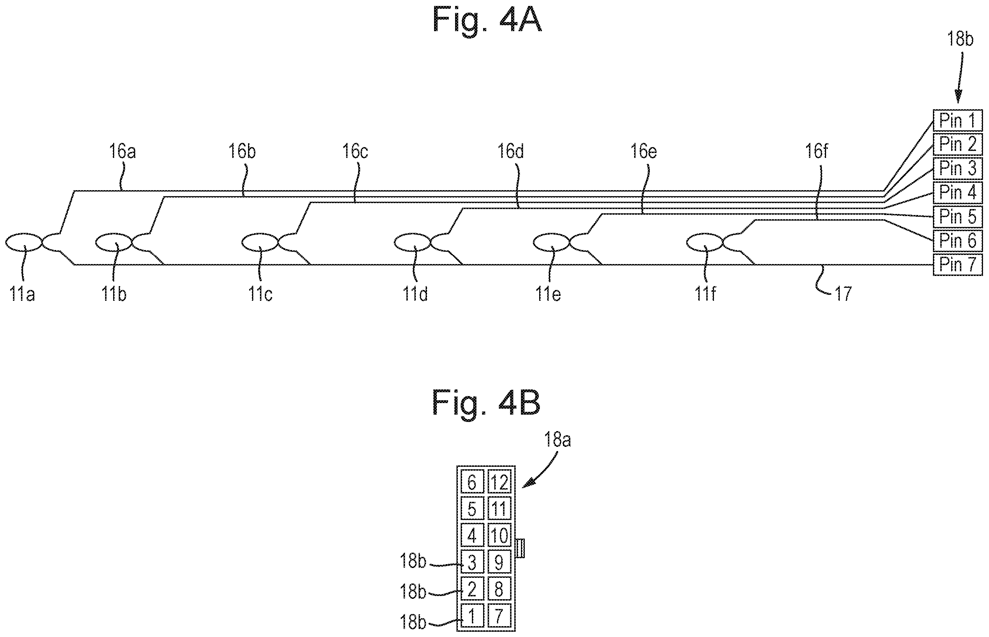

Figure 4(a) is a schematic showing a preferred circuitry layout for the heat sensor assembly of Figure 3. It will be seen that the cable provides six measurement lines 16a to 16f, one for each sensor, and a common return line 17 which is connected to ground. Each heat sensor 11a to 11f is connected to its respective measurement line 16a to 16f and to the return line 17. This design makes it possible to use a seven-core cable (one core providing each line) as the basis for the assembly 10, resulting in a small cable diameter. Each measurement line 16a to 16f and the return line 17 is connected to one of the terminal pins 18b in the end module 18 at one end of the cable. In a preferred example the end module 18 comprises a standard Molex style 12 pole connector (shown in plan view in Figure 4(b) as item 18a), in which case the return line 17 is connected to a common ground joining pins 1 to 6:

| Sensor | Connected across terminal pins | |
|---|---|---|
| 11a | 12 | 6 |
| 11b | 11 | 5 |
| 11c | 10 | 4 |
| 11d | 9 | 3 |
| 11e | 8 | 2 |
| 11f | 7 | 1 |

It will be appreciated that the same principle could be expanded to provide a different number of heat sensors 11. For example, a 16-pole connector 18a and a nine-core cable could be used to enable eight heat sensors 11 to be provided along the cable which (if spaced by 3 metres) would allow 21 metres and 8 joints per assembly 10 to be monitored.

The signal processing capability of controller 19 can be implemented in hardware, firmware or software or any combination thereof. Preferably the signal processing is carried out locally by controller 19, e.g. on a datacard provided within end module 18, but in other cases the controller could be remote with a suitable wired or wireless connection provided to enable the controller 19 to receive the signals from terminals 18b. For instance, each end module 18 could instead be provided with a communications device which simply passes the signals on to a remote controller 19, without performing local computations (other than any analogue to digital conversion or other processing that may be required to communicate the data).

The lengths of bus duct should under most circumstances have identical loads travelling through the busbars and therefore identical loads at each joint. All joints along this should be at substantially the same temperature under normal circumstances (to within a degree or two). The controller 19 is therefore configured to look for an "odd one out" scenario along the monitored joints. This routine can be performed via a number of alternative processes. In a first preferred implementation, the controller 19 performs a comparison between each temperature signal and every other temperature signal and calculates whether the difference between the temperatures is greater than a predetermined threshold ΔT_{ALARM}. For instance, in a scenario in which the temperatures of six joints A to F are monitored, the controller may carry out the following comparisons (where "Tᵢ" is the temperature of joint i, derived from the temperature signal output by the heat sensor located at joint i):
- Is T_{A} - ΔT_{ALARM} > T_{B}
- Is T_{A} - ΔT_{ALARM} > T_{C}
- Is T_{A} - ΔT_{ALARM} > T_{D}
- Is T_{A} - ΔT_{ALARM} > T_{E}
- Is T_{A} - ΔT_{ALARM} > T_{F}
- Is T_{B} - ΔT_{ALARM} > T_{A}
- Is T_{B} - ΔT_{ALARM} > T_{C}
- Is T_{B} - ΔT_{ALARM} > T_{D}
- Is T_{B} - ΔT_{ALARM} > T_{E}
- Is T_{B} - ΔT_{ALARM} > T_{F}
- Is T_{C} - ΔT_{ALARM} > T_{A}
... and so on for all pairs of joints.

In essence, this routine checks whether any joint temperature less the alarm level (ΔT_{ALARM}) is greater than the temperature of any other joint. If any one or more of the comparisons returns a positive result, the controller 19 generates an alarm signal. This could be output locally (e.g. via a sounder, light and/or display) and/or communicated to an external device such as a central controller or control panel. Preferably the alarm includes information as to which of the heat sensors has triggered the alarm so that the corresponding joint can be quickly identified.

It will be appreciated that there are other ways in which the comparisons could be performed, such as calculating whether Tᵢ - Tⱼ > ΔT_{ALARM} (where Tᵢ and Tⱼ are the temperatures of joint i and joint j respectively, derived from the temperature signal output by the heat sensors located at joint i and joint j respectively). There is no material difference between these approaches.

In alternative embodiments, the controller 19 may be configured to carry out the determination as to whether an "odd one out" situation exists in different ways. For example, it may be less computationally expensive to compare each temperature signal against an average temperature value rather than against each of the other temperature signals individually. In one preferred embodiment, therefore, where there are N heat sensors, the controller 19 may be configured to compare the temperature signals by: calculating an average (T_{AV.N}) of all of the temperature signals; for each of the temperature signals (T_{1...N}), calculating the difference between that temperature signal and the calculated average; and comparing each of the calculated differences against the predetermined threshold (ΔT_{ALARM}). Alternatively, the controller may be configured to compare the temperature signals by: for each of the temperature signals (T_{1...N}), calculating an average of all of the other temperature signals (T_{AV.N-1}) and then calculating the difference between the temperature signal and the calculated average; and comparing each of the calculated differences against the predetermined threshold (ΔT_{ALARM}). In both cases, if any of the calculated differences is found to be greater than ΔT_{ALARM}, an alarm signal will be generated.

The value of ΔT_{ALARM} can be factory-set or could be configurable by the user, e.g. via a set of DIP switches provided at the controller 19. In preferred examples, the value of ΔT_{ALARM} may be any of: 4 degrees C, 8 degrees C, 12 degrees C, 16 degrees C, 20 degrees C, 24 degrees C, 28 degrees C or 32 degrees C. A set of eight values such as this can be implemented in a user-selectable manner via a set of three DIP switches enabling the permutations 0,0,0 to 1,1,1. Of course, alternative values of ΔT_{ALARM} could be provided as appropriate to the installation. It is also possible to provide a software tool for setting of the ΔT_{ALARM} value in place of DIP switches.

Optionally, the controller 19 may be configured to run one or more additional routines, which can provide back-up alarm signals. For instance, such routines may be capable of detecting overall system failures or erroneously high loads being applied to the power distribution system. Such scenarios could cause multiple joints (e.g. all of the joints) to run hot, which would not necessarily be detected by the "odd one out" determination above.

In one embodiment, the controller 19 could therefore be further configured to run a "HIGH" function by which each temperature signal is compared against a pre-set critical temperature threshold (T_{CRIT}) and an alarm signal is generated if any of the temperature signals is greater than the pre-set critical temperature threshold (T_{CRIT}). Again, the value of T_{CRIT} could be factory-set or user configurable, e.g. via DIP switches or a software tool. Alternatively or in addition, the heat sensor assembly 10 could be provided with an ambient heat sensor 14 (Figure 3) and the controller 19 could be configured to run a "DELTA HIGH" function in which the temperature signals are compared with the local ambient temperature and an alarm triggered if the difference is greater than a pre-set critical temperature difference threshold (ΔT_{CRIT}). Again, the value of ΔT_{CRIT} could be factory-set or user configurable, e.g. via DIP switches or a software tool. For this routine the controller 19 could be configured to calculate the difference between the temperature measured by each heat sensor and the ambient temperature T_{AMB}, and check whether that difference is greater than ΔT_{CRIT}. For instance, in an assembly 10 having six heat sensors at joints A to F, the following comparisons may be performed:
- Is T_{A} - T_{AMB} > ΔT_{CRIT}
- Is T_{B} - T_{AMB} > ΔT_{CRIT}
- Is T_{C} - T_{AMB} > ΔT_{CRIT}
- Is T_{D} - T _{AMB} > ΔT_{CRIT}
- Is T_{E} - T_{AMB} > ΔT_{CRIT}
- Is T_{F} - T_{AMB} > ΔT_{CRIT}

If any of the comparisons has a positive result, an alarm signal is generated.

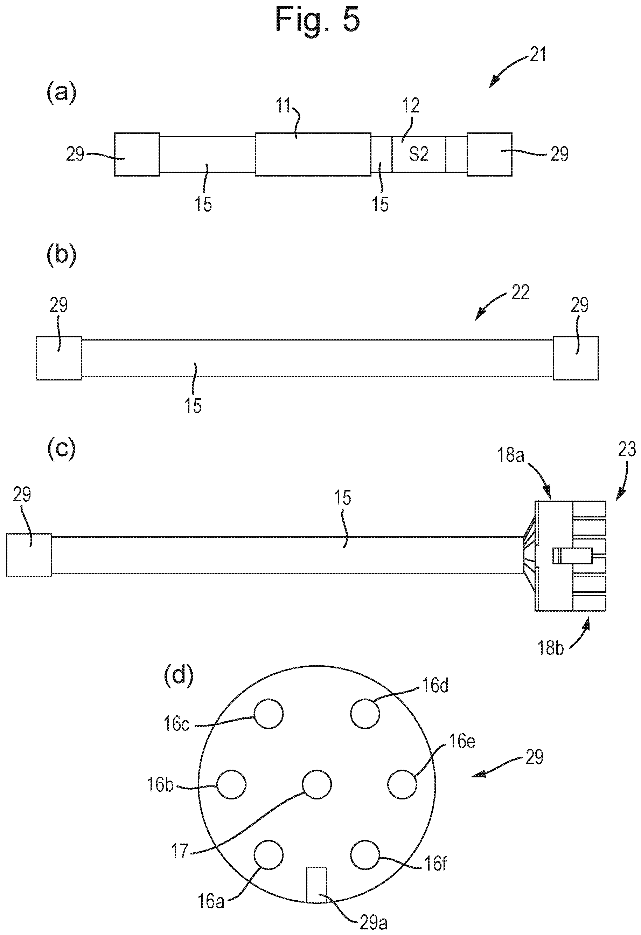

In the above embodiment, the heat sensor assembly 10 is provided as a single unit formed of a continuous cable 15 into which the heat sensors 11 are connected at the appropriate positions. However, in other implementations it may be preferable to provide the heat sensor assembly 10 in a modular form (i.e. as a kit of parts), which can be connected together to form the assembly. Figures 5(a) to (d) show such an embodiment. Here, the kit comprises a plurality of heat sensor cable sub-sections 21 (of which one is shown in Figure 5(a)) and a plurality of linking cable sub-sections 22, 23 (of which two examples are shown in Figures 5(b) and 5(c)).

The heat sensor cable sub-section 21 comprises a heat sensor 11 connected to cable portions 15 either side, provided with connectors 29 at each end. The cable 15 is a multi-core cable as previously described (e.g. a seven-core cable) and the heat sensor 11 is connected into one of the measurement lines as well as the return line running through the cable 15. The heat sensor cable sub-section 21 may be about 150mm in length for example. Preferably each one is provided with a label 12 to ensure they are connected in the correct order. The connectors 29 are multi-pin connectors, preferably of the plug-and-socket type, which enable the heat sensor cable sub-section 21 to be connected to a linking cable sub-section 22, 23 at one or both ends.

The linking cable sub-sections 22, 23 essentially each comprise a pre-made jointing cable, carrying the necessary number of lines, with a corresponding connector 29 at at least one end thereof for connection to a heat sensor cable sub-section 21. For instance, in this example the cable 15 is once again a seven-core cable. The connectors 29 may be multi-pin plug/socket connectors and a possible configuration is shown in Figure 5(d), each pin being labelled with the line of the cable to which it connects. The configuration of pins/sockets on each connector 29 is the same. Preferably the connectors 29 include a keying feature 29a to ensure that they can only be mated in one unique orientation to avoid the lines becoming crossed.

The linking cable sub-sections 23 shown in Figure 5(c) is configured to be fitted at the first end of the heat sensor assembly and therefore is provided at one of its ends with the end module 18. The controller 19 may also be provided ready connected to the junctions 18b within end module 18, or this connection could be made on-site.

A alternative method of connecting in-between the sensor modules is to use an RJ45 style socket as the connector 29 on each end of the heat sensor cable sub-section 21. This would then allow far more flexibility of loom lengths and bus duct lengths since 'off the shelf' CAT5 / 6 style patch cables could be used between modules 21 to overcome any boundaries with different lengths of duct.

Once the set of sub-sections 21, 22, 23 are connected, the result is a heat sensor assembly having substantially the same form as described with respect to Figure 3 and the same circuitry as shown in Figure 4. It will be appreciated that it the order in which the heat sensor cable sub-sections 21 are connected to to the linking cable sub-sections has a significance - they are not interchangeable, since in each one the heat sensor 11 is connected to a different one of the measurement lines 16. The measurement line to which the heat sensor is connected in each sub-section is effectively terminated at that sub-section and so the corresponding core in downstream cable sections will not carry any signal. Preferably, the heat sensors 11 are connected in a pre-determined order such that each heat sensor 11 is connected across a preselected pair of terminals 18b, the controller 19 being programmed to associate the signal across that pair of terminals with the respective heat sensor 11 (and hence the joint at that location). In this case, if the heat sensors 11 were to be connected in a different order, the terminal pairs which output the corresponding temperature signals will not be the expected pairs and hence the alarm signal may indicate the wrong joint as faulty.

Of course, if preferred, the heat sensor cable sub-sections 21 could be connected in any order (hence each one being connected across an arbitrary terminal pair). Then, a configuration process could be performed to identify which heat sensor corresponds to which temperature signal detected across the terminal pairs. For instance, this could be performed by providing a heat source adjacent each temperature sensor in turn and identifying which of the temperature signals increases. In this way the correlation between each temperature signal and each heat sensor (and hence joint location) can be established.

The modular system just described lends itself well to installation concurrently with the power distribution system 1 itself. For instance, each busbar segment 2 could be supplied pre-fitted with a linking cable sub-section 22 running along its length, either internally or externally. This is depicted schematically in Figure 6. Each busbar segment 2 may further carry a heat sensor cable sub-section 21 connected to one end of the linking cable sub-section 22, or this could supplied separately. When the power distribution system is installed, as well as connecting the busbar conductors 5 at each joint kit 6, the linking cable sub-sections 22 in each busbar segment 2 would also be connected to one another via sensor modules 21, with the heat sensors being positioned appropriately at each joint. At one end, a linking cable sub-section 23 with the end module 18 and controller 19 would be fitted to complete the heat sensor assembly 10.

Typical power distribution systems 1 will include a very large number of joints which require monitoring. Whilst in some cases it may be possible to equip a single heat sensor assembly with a correspondingly large number of heat sensors, in practice this would quickly lead to an overly large diameter cable 15 being required due to the number of lines and therefore cores needed to receive all the temperature signals. As such, it is preferable to monitor the joints using a heat sensor system 30 comprising a plurality of heat sensor assemblies 10, each as described above.

In such a heat sensor system 30, each controller 19 will require power and communications. A simple way of carrying this out would be to place a separate power adapter (e.g. a 24V DC power adapter) in each enclosure that houses one of the controllers 19 and install data communications and mains power to each heat sensor assembly 10 separately.

However a simpler and more economic method of installation can alternatively be achieved in the following manner. As shown in Figure 7, the heat sensor system 30 comprises a plurality of heat sensor assemblies 10, here 12 such assemblies. Each of the controllers 19 receives power from a common power source 31, such as a 24V DC source. This could be supplied to each controller individually. However more preferably the controllers 19 are grouped into sets of two or more controllers, each set being fitted into a small enclosure 32 of which six are provided in the Figure 7 example (enclosures 32a to 32f). In this case each set consists of two controllers 19. Each pair of assemblies 10 has its cable 15 and associated heat sensors 11 arranged to monitor joints in different (preferably opposite) directions from one another. As such, in the case that each heat sensor assembly comprises six heat sensors spaced by 3 metre intervals, this allows 33 metres of bus duct to be monitored from each enclosure 32. In the arrangement shown, each line of three enclosures 32a, 32b, 32c on one hand and 32d, 32e and 32f on the other can therefore monitor up to 105 metres of bus duct.

Preferably, each enclosure 32 is provided with a power input connection and a power output connection enabling the enclosures 32 to be connected to the common power source 31 in series as shown in Figure 7. For instance, each of the controllers 19 can typically operate from 12V dc to 24V dc therefore each enclosure 32 can be fitted with a single RJ45 socket input and a single RJ45 socket output. Internally these would be connected to each of the two controllers 19 within the enclosure 32. Both power and data can then be transmitted down the connection cable 33 (e.g. a CAT5 or better Ethernet cable) to and from each enclosure 32 which would ensure installation is optimised and simplified. Installation can for instance take place via "plug and play" approach with further assemblies 10 being added to the system 30 as and when needed. A simple to install kit can therefore be created to include pre-built enclosures 32, connected with CAT5 or better cable 33. The controllers 19 can be configured to communicate with a central controller (which may be integral with power supply unit 31), e.g. via the MODBUS protocol.

Typically, each controller 19 consumes approximately 30mA current, but if we assume a worst case of 50mA then, using a CAT5 style cable which is 0.2mm² in cross-sectional area having a resistance of 10.5 Ω per 100 metres, this gives rise to:
V=IR = 100mA *10.5Ω = 1.05V dc drop at 100 metres away
V=IR = 100mA *7Ω = 0.7 V dc drop at 66 metres away

If we increase the loading to 400mA to the furthest units
V=IR = 400mA *10.5Ω = 4.2V dc drop at 100 metres away
V=IR = 400mA *7Ω = 2.8 V dc drop at 66 metres away

Therefore, from this we can see that if 24 V dc is supplied by the common power source 31, the worst we would expect is we drop to about 19V dc at the farthest enclosures 32, which is well inside the capability of the controllers 19. This would allow one small 24vdc 2.5A power supply 31 at a central location to connect to 12 controllers 19 (six enclosures 32) and monitor 200 metres of bus duct containing 72 joints, as shown in Figure 7.

## Claims

1. A heat sensor assembly for a power distribution system (1), comprising:
a cable (15), containing a plurality of at least three heat sensors (11a, 11b, 11c) arranged along the length of the cable (15), each of the heat sensors (11) being spaced from the next by an interval;
an end module (18) at a first end of the cable (15), the end module (18) having a corresponding plurality of terminal pairs, each terminal pair being dedicated to one of the heat sensors (11);
circuitry inside the cable (15), connecting each of the heat sensors (11) across a corresponding one of the terminal pairs such that each terminal pair outputs a temperature signal indicative of the temperature sensed by the corresponding heat sensor (11); and
a controller (19) configured to receive the temperature signal from each terminal pair and to compare the temperature signals against one another to determine whether the temperature sensed by any one of the heat sensors (11) differs from that sensed by the other heat sensors (11) by more than a predetermined threshold (ΔT_{ALARM}), and if so to generate an alarm signal.

2. A heat sensor assembly according to claim 1, wherein the circuitry comprises a corresponding plurality of measurement lines (16a to 16f) and a common return line (17), each of the measurement lines (16a to 16f) connecting one of the heat sensors (11) to a first terminal of the respective terminal pair in the end module (18), and the common return line **(17)** connecting each of the heat sensors (11) to a second terminal of the respective terminal pair in the end module (18).

3. A heat sensor assembly according to claim 1 or 2, wherein the controller (19) is configured to compare the temperature signals by:
(a) for each of the temperature signals, calculating the difference between that temperature signal and each other temperature signal; and comparing each of the calculated differences against the predetermined threshold (ΔT_{ALARM}), or
(b) calculating an average of all of the temperature signals;
for each of the temperature signals, calculating the difference between that temperature signal and the calculated average; and
comparing each of the calculated differences against the predetermined threshold (ΔT_{ALARM}), or
(c) for each of the temperature signals, calculating an average of all of the other temperature signals and then calculating the difference between the temperature signal and the calculated average; and
comparing each of the calculated differences against the predetermined threshold (ΔT_{ALARM}).

4. A heat sensor assembly according to any of the preceding claims, wherein the alarm signal includes identification of which heat sensor (11) has triggered the alarm signal.

5. A heat sensor assembly according to any of the preceding claims, wherein the cable (15) comprises two or more cable segments, the cable segments being detachably joined to one another by connectors (29), the connectors (29) preferably including keying features such that they couple in a single relative orientation.

6. A heat sensor assembly according to claim 5, wherein each cable segment comprises a heat sensor cable sub-section (21) and a linking cable sub-section (22, 23), optionally detachably joined to one another by a connector (29), the heat sensor cable sub-section (21) comprising at least one of the heat sensors (11).

7. A heat sensor assembly according to any of the preceding claims, wherein the controller (19) is further configured to compare each temperature signal against a pre-set critical temperature threshold (T_{CRIT}) and to generate an alarm signal if any of the temperature signals is greater than the pre-set critical temperature threshold (T_{CRIT}).

8. A heat sensor assembly according to any of the preceding claims, further comprising an ambient temperature sensor (14) and wherein the controller (19) is further configured to, for each temperature signal, calculate the difference between the temperature signal and the ambient temperature, to compare the difference against a pre-set critical temperature difference threshold (ΔT_{CRIT}) and to generate an alarm signal if the difference is greater than the pre-set critical temperature difference threshold (ΔT_{CRIT}).

9. A heat sensor assembly according to any of the preceding claims further comprising a power module for supplying power to the controller (19) from a local or external power source.

10. A heat sensor system comprising a plurality of heat sensor assemblies each in accordance with any of claims 1 to 9, wherein the respective controllers (19) are each supplied with power from a common power source.

11. A heat sensor system according to claim 10 wherein the controllers (19) are grouped into two or more sets, each set comprising at least two of the controllers (19), each set of controllers (19) being provided with an input power connection for receiving power from the common power source and an output power connector for supplying power to another of the sets.

12. A heat sensor system according to claim 10 or 11, further comprising a central controller, the respective controllers (19) being configured to communicate with the central controller, wherein the controllers (19) are preferably grouped into two or more sets, each set comprising at least two of the controllers (19), each set of controllers (19) being provided with data connections for exchanging data with the central controller and/or with another of the sets.

13. A kit of parts, wherein when connected together the parts form a heat sensor assembly in accordance with claim 6 or any of claims 7 to 9 when dependent on claim 6, comprising: a plurality of heat sensor cable sub-sections (21) and a plurality of linking cable sub-sections (22, 23), the heat sensor cable sub-sections (21) and the linking cable sub-sections (22, 23) being detachably connectable, and one of the linking cable sub-sections (23) being provided with the end module (18).

14. A set of busbar segments (2) for a power distribution system (1), each busbar segment (2) comprising an elongate housing (4) containing conductors (5) for distributing power in use, the conductors (5) extending along the elongate length of the housing (4) between connection points at each end for joining to another one of the busbar segments (2), and each busbar segment (2) further comprising a heat sensor assembly segment comprising a cable segment including at least one heat sensor (11) and connectors at each end of the cable segment, configured such that when the set of busbar segments i(2) is connected, the joined cable segments form a cable (15) containing a plurality of at least three heat sensors (11a ,11b, 11c) arranged along the length of the cable (15), each of the heat sensors (11) being spaced from the next by an interval, and circuitry inside the cable (15), connecting each of the heat sensors (11) across one of a corresponding plurality of terminal pairs at a first end of the cable (15), to which an end module (18) can be provided in use, such that each terminal pair outputs a temperature signal indicative of the temperature sensed by the corresponding heat sensor (11).

15. A power distribution system (1) comprising one or more busbar segments (2) containing conductors (5) for distributing power in use, and a heat sensor assembly according to any of claims 1 to 9 or a heat sensor system according to any of claims 10 to 12, arranged such that each heat sensor i (11) is positioned adjacent a joint (6) in the power distribution system (1), preferably a joint (6) between busbar segments (2) or a joint (6) between a busbar segment (2) and a power outlet optionally affixed thereto.

16. A method of monitoring for faulty connections in a power distribution system (1) comprising one or more busbar segments (2) containing conductors (5) for distributing power in use, comprising:
providing a plurality of at least three heat sensors (11a, 11b, 11c), each heat sensor (11) being positioned adjacent a joint (6) in the power distribution system (1), preferably a join (6) between busbar segments (2) or a joint (6) between a busbar segment (2) and a power outlet optionally affixed thereto;
monitoring a temperature signal output by each of the plurality of heat sensors (11);
comparing the temperature signals against one another to determine whether the temperature sensed by any one of the heat sensors (11) differs from that sensed by the other heat sensors (11) by more than a predetermined threshold (ΔT_{ALARM}), and if so generating an alarm signal;
wherein the method is implemented using a heat sensor assembly according to claim 1.

## Patentansprüche

1. Wärmesensoranordnung für ein Energieverteilungssystem (1), umfassend:
ein Kabel (15), das eine Vielzahl von mindestens drei Wärmesensoren (11a, 11b, 11c) enthält, die entlang der Länge des Kabels (15) angeordnet sind, wobei jeder der Wärmesensoren (11) von dem nächsten durch einen Abstand beabstandet ist;
ein Endmodul (18) an einem ersten Ende des Kabels (15), wobei das Endmodul (18) eine entsprechende Vielzahl von Endgerätepaaren aufweist, wobei jedes Endgerätepaar einem der Wärmesensoren (11) zugeordnet ist;
eine Schaltung innerhalb des Kabels (15), die jeden der Wärmesensoren (11) über ein entsprechendes der Endgerätepaare verbindet, so dass jedes Endgerätepaar ein Temperatursignal ausgibt, das indikativ für die von dem entsprechenden Wärmesensor (11) gemessene Temperatur ist; und
eine Steuerung (19), die konfiguriert ist, um das Temperatursignal von jedem Endgerätepaar zu empfangen und die Temperatursignale miteinander zu vergleichen, um zu bestimmen, ob die von einem der Wärmesensoren (11) gemessene Temperatur von der von den anderen Wärmesensoren (11) gemessenen Temperatur um mehr als einen vorbestimmten Schwellenwert (ΔT_{ALARM}) abweicht, und wenn dies der Fall ist, ein Alarmsignal zu erzeugen.

2. Wärmesensoranordnung nach Anspruch 1, wobei die Schaltung eine entsprechende Vielzahl von Messleitungen (16a bis 16f) und eine gemeinsame Rückleitung (17) umfasst, wobei jede der Messleitungen (16a bis 16f) einen der Wärmesensoren (11) mit einem ersten Endgerät des jeweiligen Endgerätepaares im Endmodul (18) verbindet, und die gemeinsame Rückleitung (17) jeden der Wärmesensoren (11) mit einem zweiten Endgerät des jeweiligen Endgerätepaars im Endmodul (18) verbindet.

3. Wärmesensoranordnung nach Anspruch 1 oder 2, wobei die Steuerung (19) konfiguriert ist, um die Temperatursignale zu vergleichen durch:
(a) für jedes der Temperatursignale, Berechnen des Unterschieds zwischen diesem Temperatursignal und jedem anderen Temperatursignal; und
Vergleichen jedes der berechneten Unterschiede mit dem vorbestimmten Schwellenwert (ΔT_{ALARM}); oder
(b) Berechnen eines Durchschnitts aller Temperatursignale;
für jedes der Temperatursignale, Berechnen des Unterschieds zwischen diesem Temperatursignal und dem berechneten Durchschnitt; und
Vergleichen jedes der berechneten Unterschiede mit dem vorbestimmten Schwellenwert (ΔT_{ALARM}); oder
(c) für jedes der Temperatursignale Berechnen eines Durchschnitts aller anderen Temperatursignale und anschließendes Berechnen des Unterschieds zwischen dem Temperatursignal und dem berechneten Durchschnitt; und
Vergleichen jedes der berechneten Unterschiede mit dem vorbestimmten Schwellenwert (ΔT_{ALARM}).

4. Wärmesensoranordnung nach einem der vorstehenden Ansprüche, wobei das Alarmsignal eine Identifizierung einschließt, welcher Wärmesensor (11) das Alarmsignal ausgelöst hat.

5. Wärmesensoranordnung nach einem der vorstehenden Ansprüche, wobei das Kabel (15) zwei oder mehr Kabelsegmente umfasst, wobei die Kabelsegmente durch Verbinder (29) lösbar miteinander verbunden sind, wobei die Verbinder (29) vorzugsweise Verriegelungsmerkmale einschließen, so dass sie in einer einzigen relativen Ausrichtung gekoppelt sind.

6. Wärmesensoranordnung nach Anspruch 5, wobei jedes Kabelsegment einen Wärmesensorkabel-Teilabschnitt (21) und einen Verbindungskabel-Teilabschnitt (22, 23) umfasst, die gegebenenfalls durch einen Verbinder (29) lösbar miteinander verbunden sind, wobei der Wärmesensorkabel-Teilabschnitt (21) mindestens einen der Wärmesensoren (11) umfasst.

7. Wärmesensoranordnung nach einem der vorstehenden Ansprüche, wobei die Steuerung (19) weiter konfiguriert ist, um jedes Temperatursignal mit einem voreingestellten kritischen Temperaturschwellwert (T_{CRIT}) zu vergleichen und ein Alarmsignal zu erzeugen, wenn eines der Temperatursignale größer als der voreingestellte kritische Temperaturschwellwert (T_{CRIT}) ist.

8. Wärmesensoranordnung nach einem der vorstehenden Ansprüche, weiter umfassend einen Umgebungstemperatursensor (14), und wobei die Steuerung (19) weiter konfiguriert ist, um für jedes Temperatursignal den Unterschied zwischen dem Temperatursignal und der Umgebungstemperatur zu berechnen, den Unterschied mit einem voreingestellten kritischen Temperaturunterschiedsschwellenwert (ΔT_{CRIT}) zu vergleichen und ein Alarmsignal zu erzeugen, wenn der Unterschied größer als der voreingestellte kritische Temperaturunterschiedsschwellenwert (ΔT_{CRIT}) ist.

9. Wärmesensoranordnung nach einem der vorstehenden Ansprüche, die weiter ein Energiemodul zum Zuführen von Energie zu der Steuerung (19) von einer lokalen oder externen Energiequelle umfasst.

10. Wärmesensorsystem, umfassend eine Vielzahl von Wärmesensoranordnungen nach einem der Ansprüche 1 bis 9, wobei die jeweiligen Steuerungen (19) jeweils mit Energie von einer gemeinsamen Energiequelle versorgt werden.

11. Wärmesensorsystem nach Anspruch 10, wobei die Steuerungen (19) in zwei oder mehr Sätze gruppiert sind, wobei jeder Satz mindestens zwei der Steuerungen (19) umfasst, wobei jeder Satz von Steuerungen (19) mit einem Eingangsenergieanschluss zum Empfangen von Energie von der gemeinsamen Energiequelle und einem Ausgangsenergieverbinder zum Zuführen von Energie zu einem weiteren der Sätze bereitgestellt ist.

12. Wärmesensorsystem nach Anspruch 10 oder 11, ferner umfassend eine zentrale Steuerung, wobei die jeweiligen Steuerungen (19) konfiguriert sind, um mit der zentralen Steuerung zu kommunizieren, wobei die Steuerungen (19) vorzugsweise in zwei oder mehr Sätze gruppiert sind, wobei jeder Satz mindestens zwei der Steuerungen (19) umfasst, wobei jeder Satz von Steuerungen (19) mit Datenverbindungen zum Austauschen von Daten mit der zentralen Steuerung und/oder mit einem weiteren der Sätze bereitgestellt ist.

13. Kit-of-parts, wobei die Teile, wenn sie miteinander verbunden sind, eine Wärmesensor-Anordnung nach Anspruch 6 oder einem der Ansprüche 7 bis 9, wenn sie von Anspruch 6 abhängig sind, bilden, umfassend: eine Vielzahl von Wärmesensorkabel-Teilabschnitten (21) und eine Vielzahl von Verbindungskabel-Teilabschnitten (22, 23), wobei der Wärmesensor-Kabelteilabschnitt (21) und die Verbindungskabelteilabschnitte (22, 23) lösbar miteinander verbindbar sind und einer der Verbindungskabelteilabschnitte (23) mit dem Endmodul (18) bereitgestellt ist.

14. Satz von Sammelschienensegmenten (2) für ein Energieverteilungssystem (1), wobei jedes Sammelschienensegment (2) ein längliches Gehäuse (4) umfasst, das Leiter (5) zum Verteilen von Energie im Gebrauch enthält, wobei sich die Leiter (5) entlang der länglichen Länge des Gehäuses (4) zwischen Verbindungspunkten an jedem Ende zum Beitreten zu einem weiteren der Sammelschienensegmente (2) erstrecken, und jedes Sammelschienensegment (2) weiter ein Wärmesensor-Anordnungssegment umfasst, das ein Kabelsegment einschließlich mindestens eines Wärmesensors (11) und Verbinder an jedem Ende des Kabelsegments umfasst, die so konfiguriert sind, dass, wenn der Satz von Sammelschienensegmenten (2) verbunden ist, die verbundenen Kabelsegmente ein Kabel (15) bilden, das eine Vielzahl von mindestens drei Wärmesensoren (11a, 11b, 11c) enthält, die entlang der Länge des Kabels (15) angeordnet sind, wobei jeder der Wärmesensoren (11) von dem nächsten durch einen Abstand beabstandet ist, und eine Schaltung innerhalb des Kabels (15), die jeden der Wärmesensoren (11) über eines einer entsprechenden Vielzahl von Endgerätepaaren an einem ersten Ende des Kabels (15) verbinden, an dem im Gebrauch ein Endmodul (18) bereitgestellt werden kann, so dass jedes Endgerätepaar ein Temperatursignal ausgibt, das die von dem entsprechenden Wärmesensor (11) gemessene Temperatur angibt.

15. Energieverteilungssystem (1), umfassend ein oder mehrere Sammelschienensegmente (2), die Leiter (5) zur Verteilung von Energie im Gebrauch enthalten, und eine Wärmesensor-Anordnung nach einem der Ansprüche 1 bis 9 oder ein Wärmesensorsystem nach einem der Ansprüche 10 bis 12, die so angeordnet sind, dass jeder Wärmesensor (11) angrenzend an eine Verbindung (6) in dem Energieverteilungssystem (1) positioniert ist, vorzugsweise einer Verbindung (6) zwischen Sammelschienensegmenten (2) oder einer Verbindung (6) zwischen einem Sammelschienensegment (2) und einem gegebenenfalls daran befestigten Energieausgang.

16. Verfahren zur Überwachung von fehlerhaften Verbindungen in einem Energieverteilungssystem (1), das ein oder mehrere Sammelschienensegmente (2) umfasst, die Leiter (5) zur Verteilung von Energie im Betrieb enthalten, umfassend:
Bereitstellen einer Vielzahl von mindestens drei Wärmesensoren (11a, 11b, 11c), wobei jeder Wärmesensor (11) angrenzend an eine Verbindung (6) in dem Energieverteilungssystem (1) positioniert ist, vorzugsweise an eine Verbindung (6) zwischen Sammelschienensegmenten (2) oder an eine Verbindung (6) zwischen einem Sammelschienensegment (2) und einem gegebenenfalls daran befestigten Energieausgang;
Überwachen eines Temperatursignals, das von jedem der Vielzahl von Wärmesensoren (11) ausgegeben wird;
Vergleichen der Temperatursignale miteinander, um zu bestimmen, ob die von einem der Wärmesensoren (11) gemessene Temperatur von der von den anderen Wärmesensoren (11) gemessenen Temperatur um mehr als einen vorbestimmten Schwellenwert (ΔT_{ALARM}) abweicht, und wenn dies der Fall ist, Erzeugen eines Alarmsignals.
wobei das Verfahren unter Verwendung einer Wärmesensoranordnung nach Anspruch 1 implementiert ist.

## Revendications

1. Ensemble capteur de chaleur pour un système de distribution d'énergie (1), comprenant :
un câble (15), comprenant une pluralité d'au moins trois capteurs de chaleur (11a, 11b, 11c) disposés sur la longueur du câble (15), chacun des capteurs de chaleur (11) étant espacé du capteur suivant par un intervalle ;
un module d'extrémité (18) à une première extrémité du câble (15), le module d'extrémité (18) comportant une pluralité correspondante de paires de bornes, chaque paire de bornes étant dédiée à l'un des capteurs de chaleur (11) ;
un ensemble de circuits à l'intérieur du câble (15), connectant chacun des capteurs de chaleur (11) à une paire de bornes correspondante parmi les paires de bornes, de telle sorte que chaque paire de bornes émette un signal de température indiquant la température détectée par le capteur de chaleur (11) correspondant ; et
un dispositif de commande (19) conçu pour recevoir le signal de température de chaque paire de bornes et pour comparer les signaux de température les uns aux autres pour déterminer si la température détectée par l'un quelconque des capteurs de chaleur (11) diffère de celle détectée par les autres capteurs de chaleur (11) de plus d'un seuil (ΔT_{ALARM}) prédéterminé, et si tel est le cas, pour générer un signal d'alarme.

2. Ensemble capteur de chaleur selon la revendication 1, dans lequel l'ensemble de circuits comprend une pluralité correspondante de lignes de mesure (16a à 16f) et une ligne de retour (17) commune, chacune des lignes de mesure (16a à 16f) connectant l'un des capteurs de chaleur (11) à une première borne de la paire de bornes respective dans le module d'extrémité (18), et la ligne de retour (17) commune connectant chacun des capteurs de chaleur (11) à une seconde borne de la paire de bornes respective dans le module d'extrémité (18).

3. Ensemble capteur de chaleur selon la revendication 1 ou 2, dans lequel le dispositif de commande (19) est conçu pour comparer les signaux de température :
(a) par calcul, pour chacun des signaux de température, de la différence entre ce signal de température et chaque autre signal de température ; et
par comparaison de chacune des différences calculées au seuil (ΔT_{ALARM}) prédéterminé ; ou
(b) par calcul d'une moyenne de tous les signaux de température ;
par calcul, pour chacun des signaux de température, de la différence entre ce signal de température et la moyenne calculée ; et
par comparaison de chacune des différences calculées au seuil (ΔT_{ALARM}) prédéterminé ; ou
(c) par calcul, pour chacun des signaux de température, d'une moyenne de tous les autres signaux de température, puis par calcul de la différence entre le signal de température et la moyenne calculée ; et
par comparaison de chacune des différences calculées au seuil (ΔT_{ALARM}) prédéterminé.

4. Ensemble capteur de chaleur selon l'une quelconque des revendications précédentes, dans lequel le signal d'alarme comprend l'identification du capteur de chaleur (11) qui a déclenché le signal d'alarme.

5. Ensemble capteur de chaleur selon l'une quelconque des revendications précédentes, dans lequel le câble (15) comprend au moins deux segments de câble, les segments de câble étant reliés de manière détachable les uns aux autres au moyen de connecteurs (29), les connecteurs (29) comprenant de préférence des éléments d'encastrement, de telle sorte qu'ils s'accouplent dans une seule orientation relative.

6. Ensemble capteur de chaleur selon la revendication 5, dans lequel chaque segment de câble comprend une sous-section de câble de capteur de chaleur (21) et une sous-section de câble de connexion (22, 23), éventuellement reliées de manière détachable l'une à l'autre au moyen d'un connecteur (29), la sous-section de câble de capteur de chaleur (21) comprenant au moins l'un des capteurs de chaleur (11).

7. Ensemble capteur de chaleur selon l'une quelconque des revendications précédentes, dans lequel le dispositif de commande (19) est en outre conçu pour comparer chaque signal de température à un seuil de température critique (T_{CRIT}) prédéfini et pour générer un signal d'alarme lorsque l'un quelconque des signaux de température est supérieur au seuil de température critique (T_{CRIT}) prédéfini.

8. Ensemble capteur de chaleur selon l'une quelconque des revendications précédentes, comprenant en outre un capteur de température ambiante (14) et dans lequel le dispositif de commande (19) est en outre conçu, pour chaque signal de température, pour calculer la différence entre le signal de température et la température ambiante, pour comparer la différence à un seuil de différence de température critique (ΔT_{CRIT}) prédéfini et pour générer un signal d'alarme lorsque la différence est supérieure au seuil de différence de température critique (ΔT_{CRIT}) prédéfini.

9. Ensemble capteur de chaleur selon l'une quelconque des revendications précédentes, comprenant en outre un module d'alimentation pour alimenter en énergie le dispositif de commande (19) à partir d'une source d'énergie locale ou externe.

10. Système de capteur de chaleur comprenant une pluralité d'ensembles capteurs de chaleur, chacun conforme à l'une quelconque des revendications 1 à 9, dans lequel les dispositifs de commande (19) respectifs sont chacun alimentés en énergie à partir d'une source d'énergie commune.

11. Système de capteur de chaleur selon la revendication 10, dans lequel les dispositifs de commande (19) sont regroupés en au moins deux ensembles, chaque ensemble comprenant au moins deux des dispositifs de commande (19), chaque ensemble de dispositifs de commande (19) étant pourvu d'une connexion d'alimentation d'entrée pour recevoir de l'énergie de la source d'alimentation commune et d'un connecteur d'alimentation de sortie pour alimenter en énergie un autre des ensembles.

12. Système de capteur de chaleur selon la revendication 10 ou 11, comprenant en outre un dispositif de commande central, les dispositifs de commande (19) respectifs étant conçus pour communiquer avec le dispositif de commande central, dans lequel les dispositifs de commande (19) sont de préférence regroupés en au moins deux ensembles, chaque ensemble comprenant au moins deux des dispositifs de commande (19), chaque ensemble de dispositifs de commande (19) étant pourvu de connexions de données pour échanger des données avec le dispositif de commande central et/ou avec un autre des ensembles.

13. Kit de pièces, dans lequel, lorsqu'elles sont connectées, les pièces forment un ensemble capteur de chaleur selon la revendication 6 ou l'une quelconque des revendications 7 à 9 lorsqu'elles dépendent de la revendication 6, comprenant : une pluralité de sous-sections de câble de capteur de chaleur (21) et une pluralité de sous-sections de câble de liaison (22, 23), la sous-section de câble de capteur de chaleur (21) et les sous-sections de câble de liaison (22, 23) pouvant être connectées de manière détachable, et l'une des sous-sections de câble de liaison (23) étant pourvue du module d'extrémité (18).

14. Ensemble de segments de barre omnibus (2) pour un système de distribution d'énergie (1), chaque segment de barre omnibus (2) comprenant un boîtier (4) allongé comprenant des conducteurs (5) pour la distribution d'énergie lors de l'utilisation, les conducteurs (5) s'étendant sur toute la longueur du boîtier (4) entre des points de connexion à chaque extrémité pour permettre la jonction à un autre segment parmi les segments de barre omnibus (2), et chaque segment de barre omnibus (2) comprenant en outre un segment d'ensemble capteur de chaleur comprenant un segment de câble comprenant au moins un capteur de chaleur (11) et des connecteurs à chaque extrémité du segment de câble, conçus de telle sorte que, lorsque l'ensemble de segments de barre omnibus (2) est connecté, les segments de câble joints forment un câble (15) comprenant une pluralité d'au moins trois capteurs de chaleur (11a, 11b, 11c) disposés sur la longueur du câble (15), chacun des capteurs de chaleur (11) étant espacé du capteur suivant par un intervalle, et un ensemble de circuits à l'intérieur du câble (15), connectant chacun des capteurs de chaleur (11) à une paire de bornes d'une pluralité correspondante de paires de bornes à une première extrémité du câble (15), auquel un module d'extrémité (18) peut être fourni lors de l'utilisation, de telle sorte que chaque paire de bornes émet un signal de température indiquant la température détectée par le capteur de chaleur (11) correspondant.

15. Système de distribution d'énergie (1) comprenant au moins un segment de barre omnibus (2) comprenant des conducteurs (5) pour la distribution d'énergie lors de l'utilisation, et un ensemble capteur de chaleur selon l'une quelconque des revendications 1 à 9 ou un système de capteurs de chaleur selon l'une quelconque des revendications 10 à 12 conçus de telle sorte que chaque capteur de chaleur (11) est positionné adjacent à un raccord (6) dans le système de distribution d'énergie (1), de préférence un raccord (6) entre des segments de barre omnibus (2) ou un raccord (6) entre un segment de barre omnibus (2) et une sortie d'alimentation éventuellement fixée à celui-ci.

16. Procédé de surveillance des connexions défectueuses dans un système de distribution d'énergie (1) comprenant au moins un segment de barre omnibus (2) comprenant des conducteurs (5) pour distribuer l'énergie lors de l'utilisation, comprenant :
la fourniture d'une pluralité d'au moins trois capteurs de chaleur (11a, 11b, 11c), chaque capteur de chaleur (11) étant positionné adjacent à un raccord (6) dans le système de distribution d'énergie (1), de préférence un raccord (6) entre des segments de barre omnibus (2) ou un raccord (6) entre un segment de barre omnibus (2) et une sortie d'alimentation éventuellement fixée à celui-ci ;
la surveillance d'un signal de température émis par chaque capteur de la pluralité de capteurs de chaleur (11) ;
la comparaison des signaux de température les uns aux autres pour déterminer si la température détectée par l'un quelconque des capteurs de chaleur (11) diffère de celle détectée par les autres capteurs de chaleur (11) de plus d'un seuil (ΔT_{ALARM}) prédéterminé, et si tel est le cas, la génération d'un signal d'alarme ;
dans lequel le procédé est mis en œuvre à l'aide d'un ensemble capteur de chaleur selon la revendication 1.
